# EUROPÄISCHE PATENTSCHRIFT

(11) **EP 1 608 535 B1**
(45) Veröffentlichungstag und Bekanntmachung des Hinweises auf die Patenterteilung: **04.07.2007**
(21) Anmeldenummer: 04725290.3
(22) Anmeldetag: 02.04.2004
(51) Int. Cl.: B60R 16/02, H05K 1/11

(54) **ANORDNUNG VON ELEKTRISCHEN UND/ODER MECHANISCHEN KOMPONENTEN AUF EINER GROSSEN, FLEXIBLEN FOLIENLEITERFLÄCHE**
ARRANGEMENT OF ELECTRICAL AND/OR MECHANICAL COMPONENTS ON A LARGE, FLEXIBLE FOIL-TYPE CONDUCTOR AREA
DISPOSITION D'ELEMENTS ELECTRIQUES ET/OU MECANIQUES SUR UNE SURFACE CONDUCTRICE EN FEUILLE SOUPLE DE GRANDE DIMENSION

(30) Priorität: 03.04.2003 DE 10315438
(43) Veröffentlichungstag der Anmeldung: 28.12.2005
(73) Patentinhaber: Conti Temic microelectronic GmbH, 90411 Nürnberg (DE)
(72) Erfinder: BÜYÜKBAS, Turhan, 95158 Kirchenlamitz (DE); GRAMANN, Matthias, 77871 Renchen (DE); SCHARRER, Klaus, 91224 Hohenstadt (DE); GUTH, Peter, 90419 Nürnberg (DE); BUHL, Joachim, 90429 Nürnberg (DE); KLEIN, Dominik, 90411 Nürnberg (DE); SCHUCH, Bernhard, 91616 Neusitz (DE); LIEBL, Thilo, 91217 Hersbruck (DE)
(86) Internationale Anmeldenummer: PCT/DE2004/000717
(87) Internationale Veröffentlichungsnummer: WO 2004/087466

(56) Entgegenhaltungen:
- EP-A- 0 490 530
- DE-A- 3 842 340
- DE-A- 10 134 621
- GB-A- 1 413 518
- GB-A- 2 275 373
- US-A- 6 088 241

## Beschreibung

Die Erfindung betrifft eine Anordnung von elektrischen und/ oder mechanischen Komponenten auf einer großen, flexiblen Folienleiterfläche und ein Verfahren zur Herstellung einer solchen Anordnung.

Der flexible Folienleiter als Verbindungselement für unterschiedliche Komponenten findet Dank seiner Vorzüge immer mehr Verbreitung, so zum Beispiels im Automobilbau. So wird zum Beispiel bei der Herstellung eines Steuergerätes für ein KFZ-Getriebe üblicherweise zuerst das Layout für die Anordnung der Gesamtheit der elektrischen und/oder mechanischen Komponenten erstellt. Danach wird ein Folienleiterstück, das der Verbindung der elektrischen und/oder mechanischen Komponenten untereinander dient, dem Layout entsprechend aus einer großen, standardisierten Folienleiterfläche herausgetrennt. Danach wird das Folienleiterstück mit einer Grundplatte verbunden. Anschließend werden die Komponenten angeordnet und mit dem Folienleiterstück verbunden.

Schon bei einem weniger komplizierten Folienlayout kommt es bei dieser Vorgehensweise zu einem hohen Verschnitt an teuerer Folie. Darüber hinaus kann erst in einem relativ späten Zeitpunkt des Herstellungsprozesses die Qualität der Kontakte der Komponenten zum Folienleiter geprüft werden. Das kann unter Umständen aufwendige Nacharbeit oder gar kostspieligen Ausschuss zur Folge haben.

In der Patentschrift DE 197 51 095 C1, welches die Merkmale der Oberbegriffe der Ansprüche 1 und 5 zeigt, wird die Anordnung einer Steuereinheit im Inneren eines Getriebegehäuses eines Kraftfahrzeuges beschrieben, bei der das elektrische Verbindungselement zwischen der Steuereinheit und den elektrischen Bauteilen außerhalb des Gehäuses aus einem einzigen flexiblen Folienleiter besteht und eine Doppelfunktion ausübt, nämlich zum einen die Steuereinheit mit den elektrischen Bauteilen außerhalb des Gehäuses zu verbinden und zum anderen mehrere im Gehäuse vorhandene Bauteile gemeinsam zu kontaktieren. Die Steuereinheit umfasst wenigstens zwei öldicht miteinander verbundene Gehäuseteile, durch die das elektrische Verbindungselement hindurchgeführt ist.

Der flexible Folienleiter ist dabei aus einem Stück, was bei komplexen Anordnungen, rechnet man nur die Aussparung für die Steuereinheit in der Mitte des Folienleiters, zu einem großen Verschnitt führt und deshalb unwirtschaftlich ist.

Darüber hinaus ist mit der Form des Folienleiters die Position der elektrischen Bauteile sowohl innerhalb als auch außerhalb des Gehäuses festgelegt und erfordert bei der Änderung der Lage nur eines Bauteiles die Änderung der Form des ganzen Folienleiters. Im Herstellungsprozess stellt dies eine gravierende Einschränkung der Gestaltungsmöglichkeiten dar.

Ein weiterer Nachteil dieser Anordnung ist, dass die Funktions- und Qualitätsprüfung, beispielsweise bezüglich der Dichtheit der Anordnung oder der Güte der elektrischen Kontakte, erst sehr spät im Herstellungsprozess geprüft werden kann. Was unter Umständen sehr teuere Nacharbeit oder sogar hohe Ausschusskosten zur Folge haben kann.

Der vorliegenden Erfindung liegt die Aufgabe zugrunde, eine einfach und flexibel handhabbare, kostengünstige und prozesssichere Anordnung von elektrischen und mechanischen Komponenten auf einer großen, flexiblen Folienleiterfläche herzustellen und das Verfahren zur Herstellung einer solchen Anordnung zu schaffen.

Diese Aufgabe wird durch eine Anordnung nach den Merkmalen des Anspruchs 1 und durch ein Verfahren nach den Merkmalen des Anspruchs 5 gelöst.

Hierbei werden mehrere elektrische und mechanische Komponenten auf der großen Folienleiterfläche in geeignete Baugruppen zusammengefasst. Dabei sind die einzelnen Baugruppen so auf Folienleiterteilflächen angeordnet, dass deren Begrenzungslinien möglichst lang sind und dabei möglichst parallel zu den Begrenzungslinien der großen Folienleiterfläche verlaufen. Idealerweise sind die Folienleiterteilflächen als parallele Streifen ausgebildet. Dadurch wird der Verschnitt an der großen Folienleiterfläche minimiert.

Die Anordnung ist äußerst variabel, da jede Baugruppe voneinander verschiedene elektrische und mechanische Komponenten umfassen kann. Insbesondere kann sich innerhalb einer großen Folienleiterfläche jede Baugruppe von der anderen unterscheiden. Dies ist idealer Weise geeignet für den Einsatz in der Entwicklungsphase oder bei Klein- und Kleinstserien.

Vorteilhafterweise geschieht beim erfindungsgemäßen Verfahren das elektrische und mechanische Verbinden der elektrischen und mechanischen Komponenten mit dem Folienleiter schon auf der großen Folienleiterfläche. Dadurch kann die Qualität der Verbindungen schon auf der großen Folienleiterfläche geprüft werden. Danach können die geprüften Folienleiterteilstücke mit den dazugehörigen Komponenten abgetrennt und dem nachfolgenden Herstellungsschritt zugeführt werden. Dies erhöht die Prozesssicherheit des gesamten Herstellungsverfahrens.

Vorzugsweise sind die Folienleiterteilstücke auf der großen Folienleiterfläche so angeordnet, dass nach dem Abtrennen der letzten Folienleiterteilfläche er Folienverschnitt auf ein Minimum reduziert ist.

Nach einer vorteilhaften Ausgestaltung der Erfindung geschieht die mechanische Verbindung der mechanischen Komponenten zur Folienleiterfläche durch auflaminieren, SMD-bestücken oder mechanisches fügen. Dadurch wird ein umständlicher Klebeprozess vermieden.

Bevorzugter Weise wird die mechanische Verbindung der elektrischen Komponenten zur Folienleiterfläche durch verlöten oder verschweißen geschaffen. Dies garantiert einen schnellen und sicheren Herstellungsprozess.

Vorzugsweise sind auf der der mechanischen Komponente gegenüber liegenden Seite der Folienleiterfläche elektrische Kontaktflächen angebracht. Dadurch kann im weiteren Herstellungsprozess eine elektrische Verbindung zu anderen elektrischen Bauteilen und Folienleitern hergestellt werden.

Vorteilhafterweise sind die mechanischen Komponenten als flache, quaderförmige Platten aus Metall oder Kunststoff ausgebildet. Diese Platten können als Unterstützung bei der Herstellung der elektrischen Verbindung zwischen den Kontaktflächen, die sich auf der den mechanischen Komponenten gegenüberliegenden Folienleiterfläche befinden, und weiteren elektrischen Komponenten und Folienleitern dienen. Desweiteren können diese Platten auch im weiteren Herstellungsprozess als Teile eines Gesamtgehäuses verwendet werden und unter Umständen zusätzlich eine das Gehäuse abdichtende Wirkung haben.

Nach einem besonders bevorzugten Ausführungsbeispiel der vor-liegenden Erfindung sind die elektrischen Komponenten vorzugsweise Sensoren oder Aktuatoren. Sie sind insbesondere über separate Kontakte mit der Folienleiterfläche verbunden. Die Qualität der Verbindung der elektrischen und der mechanischen Komponenten zur Folienleiterfläche kann schon direkt nach der Herstellung der jeweiligen Verbindung geprüft werden. Dadurch wird im Gesamtfertigungsprozess die Sicherheit erhöht und durch Wegfall einer eventuell, durch Verwendung einer ungeprüften, schadhaften Baugruppe verursachten Nacharbeit werden Kosten gespart.

Eine nähere Beschreibung der vorliegenden Erfindung erfolgt anhand der beigefügten Zeichnungen.
Fig. 1 zeigt eine Draufsicht auf die Anordnung der elektrischen und der mechanischen Komponenten auf der großen Folienleiterfläche;
Fig. 2 zeigt einen Schnitt durch die Fig. 1 in der Ebene A-A.
Fig.3 zeigt einen Auszug aus einer schematischen Querschnittansicht eines Gehäuses, wobei die mechanische Komponente als Teil des Gehäuses verwendet wird

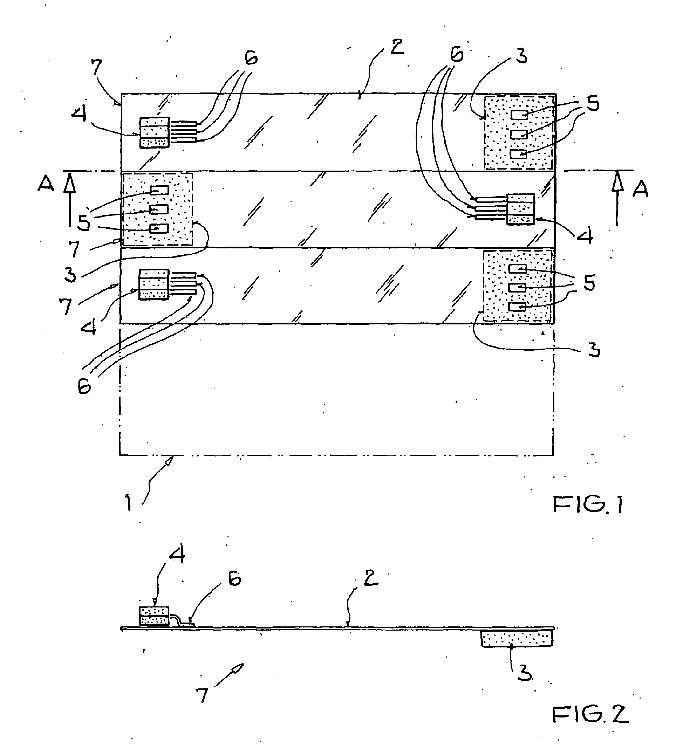

Fig. 1 und 2 zeigen ein bevorzugtes Ausgestaltungsbeispiel der Erfindung, wobei die einzelnen Baugruppen 7, die jeweils eine elektrische Komponente 4, hier ein Aktuator oder Sensor als SMD-Bauteil, ein Folienleiterstück 2 und eine quaderförmige Platte als mechanische Komponente 3, nachfolgend Bondplatte genannt, umfassen, identisch sind. Die Folienleiterstücke 2 sind als parallele Streifen auf der großen Folienleiterfläche 1 ausgeführt, was idealer Weise den Verschnitt auf null reduziert.

Die Komponenten 3 und 4 sind jeweils am Ende des Folienleiterstreifens 2 gegenüberliegend angeordnet, wobei die elektrische Komponente 4 auf der Oberseite, und die mechanische Komponente 3 auf der Unterseite angeordnet ist. Die mechanische Verbindung der elektrische Komponente 4 zum Folienleiterstück 2 kann durch verlöten oder verschweißen bewerkstelligt werden; elektrisch sind sie insbesondere über den Kontakt 6 mit dem Folienleiterstück 2 verbunden.

Die mechanische Verbindung der Bondplatte 3 zum Folienleiterstück 2 wird zum Beispiel durch auflaminieren, SMD-bestücken geschaffen; denkbar wäre auch eine Verbindung durch mechanisches fügen. Auf der der Bondplatte 3 gegenüber liegenden Seite sind auf dem Folienleiterstück 2 Kontaktflächen 5 vorgesehen, durch die im nachfolgenden Herstellungsprozess weitere elektrische Bauteile über das Folienleiterstück 2 mit dem SMD-Bauteil 4 elektrisch verbunden werden können.

Die Qualität der elektrischen und/oder der mechanischen Verbindungen kann direkt im Anschluss an ihre Herstellung geprüft werden. Wenn alle Komponenten 3 und/oder 4 auf der großen Folienleiterfläche angeordnet sind, können die einzelnen Baugruppen 7 abgetrennt und weiterverarbeitet werden.

Die/Erfindung umfasst natürlich alle möglichen Kombinationen der elektrischen und/oder der mechanischen Komponenten 3, 4 auf der Oberseite und/oder Unterseite der großen Folienleiterfläche 1 und diese können auch von Baugruppe 7 zu Baugruppe 7 innerhalb einer Folienleiterfläche variieren. Die Form der jeweiligen Baugruppe 7 richtet sich nach den jeweiligen Erfordernissen und kann ebenfalls von Baugruppe 7 zu Baugruppe 7 innerhalb der großen Folienleiterfläche 1 verschieden sein.

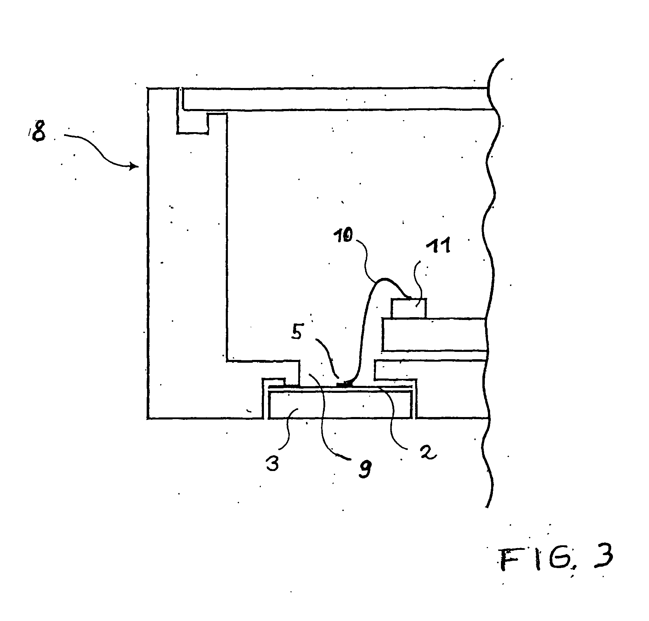

Fig.3 zeigt einen Auszug aus einer schematischen Querschnittansicht eines Gehäuses 8, wobei die Bondplatte 3 als Teil des Gehäuses 8 verwendet wird. Das Gehäuse 8 weist am Boden eine Aussparung 9 auf, in die die Bondplatte 3 so eingepasst ist, dass sich das Folienleiterstück 2 zwischen der Bondplatte 3 und dem Gehäuse 8 befindet. Der Bonddraht 10 stellt die elektrische Verbindung zwischen der Kontaktfläche 5 auf dem Folienleiterstück 2 und der elektrischen Einheit 11 im Inneren des Gehäuses 8 her. Somit wird durch die Baugruppe 7 die elektrische Einheit 11 im Inneren des Gehäuses 8 mit dem SMD-Bauteil 4 außerhalb des Gehäuses 8 elektrisch verbunden. Die Bondplatte 3 kann beispielsweise durch Verschrauben oder Verstemmen in die Aussparung 9 eingebracht werden. Zusammen mit dem Folienleiterstück 2 kann die Bondplatte 3 auch eine das Gehäuse 8 abdichtende Wirkung haben, insbesondere gegen Öl. Die Dichtwirkung kann in nicht gezeigter Weise durch Anbringen einer zusätzlichen Dichtung zwischen Folienleiterstück 2 und Gehäuse 8 erhöht werden.

### Bezugszeichenliste:

- 1: Große flexible Folienleiterfläche
- 2: Folienleiterstück
- 3: Mechanische Komponenten
- 4: Elektrische Komponente
- 5: Kontaktfläche
- 6: Kontakt
- 7: Baugruppe
- 8: Gehäuse
- 9: Aussparung
- 10: Bonddraht
- 11: Elektrische Einheit

## Patentansprüche

1. Anordnung von elektrischen und mechanischen Komponenten (3, 4) auf einem flexiblen Folienleiter, , der
- eine große, standardisierte Folienleiterfläche (1) ist; **dadurch gekennzeichnet, dass**
- die mechanischen Komponenten (3) mechanisch mit der Folienleiterfläche (1) verbunden sind;
- die elektrischen Komponenten (4) mechanisch mit der Folienleiterfläche (1) verbunden sind;
- die elektrischen Komponenten (4) elektrisch mit der Folienleiterfläche (1) verbunden sind,
und dass mehrere elektrische und mechanische Komponenten (3, 4) so auf der Folienleiterfläche (1) zu Baugruppen (7) zusammengefasst_sind, dass die einzelnen Baugruppen (7) auf Folienleiterteilflächen (2) angeordnet sind, die möglichst lange, parallel zu den Begrenzungslinien der großen, standardisierten Folienleiterfläche (1) verlaufende Begrenzungslinien aufweisen.

2. Anordnung nach Anspruch 1, **dadurch gekennzeichnet, dass** die mechanischen Komponenten (3) quaderförmige Platten aus Metall oder Kunststoff sind.

3. Anordnung nach Anspruch 1 oder 2, **dadurch gekennzeichnet, dass** die mechanischen Komponenten (3) Teil eines Gehäuses (8) sind.

4. Anordnung nach Anspruch 1 , **dadurch gekennzeichnet, dass** die elektrischen Komponenten (4) Sensoren oder Aktuatoren oder sonstige elektrische Bauteile sind.

5. Verfahren zur Herstellung von mehreren Baugruppen (7), die jeweils elektrische und mechanische Komponenten (3, 4) umfassen, auf einer großen, standardisierten Folienleiterfläche (1) **dadurch gekennzeichnet, dass**, zumindest für eine Baugruppe (7)
- die mechanischen Komponenten (3) mechanisch mit der Folienleiterfläche (1) verbunden werden
- die elektrischen Komponenten (4) mechanisch mit der Folienleiterfläche (1) verbunden werden
- die elektrischen Komponenten (4) elektrisch mit der Folienleiterfläche (1) verbunden werden und
- jeweils derjenige Teil (2) der Folienleiterfläche (1), der jeweils eine Baugruppe (7) umfasst, entlang von vorgegebenen Begrenzungslinien von der Folienleiterfläche (1) getrennt wird.

6. Verfahren nach Anspruch 5, **dadurch gekennzeichnet, dass** mehrere elektrische und mechanische Komponenten (3, 4) so auf der Folienleiterfläche (1) zu Baugruppen (7) zusammengefasst sind, dass die einzelnen Baugruppen (7) auf Folienleiterteilflächen (2) angeordnet sind, die möglichst lange, parallel zu den Begrenzungslinien der großen, standardisierten Folienleiterfläche (1) verlaufende Begrenzungslinien aufweisen.

7. Verfahren nach einem der vorangegangenen Ansprüche 5 oder 6 zur Herstellung von Baugruppen (7), die mehrere elektrische und mechanische Komponenten (3, 4) umfassen, auf Folienleiterteilflächen (2), **dadurch gekennzeichnet, dass**
- die mechanische Verbindung der mechanischen Komponenten (3) durch auflaminieren, SMD-bestücken oder mechanisches fügen geschieht;
- auf der der mechanischen Komponente (3) gegenüber liegenden Seite der Folienleiterteilfläche (2) elektrische Kontaktflächen angebracht werden;
- die mechanische Verbindung der elektrischen Komponenten (4) durch verlöten oder verschweißen geschieht;
- die elektrische Verbindung der elektrischen Komponenten (4) durch die Kontakte (6) hergestellt wird.

8. Verfahren nach Anspruch 7, **dadurch gekennzeichnet, dass** die Verteilung der Folienleiterteilflächen (2) auf der großen Folienleiterfläche (1), die Lage der Begrenzungslinien und die daraus resultierende Form der Folienleiterteilflächen (2) inklusive der Verteilung der Komponenten (3, 4) auf der Folienleiterteilfläche (2) derart gewählt werden, dass der beim Abtrennen verbleibende Rest auf ein Minimum reduziert ist.

## Claims

1. An arrangement of electrical and mechanical components (3, 4) on a flexible foil conductor, which
- Is a large, standardised foil conductor surface (1); **characterized in that**
- the mechanical components (3) are mechanically connected to the foil conductor surface (1);
- the electrical components (4) are mechanically connected to the foil conductor surface (1);
- the electrical components (4) are electrically connected to the foil conductor surface (1),
and that several electrical and mechanical components (3, 4) are compiled on the foil conductor surface (1) into assembly groups (7) in such a manner that the individual assembly groups (7) are arranged on partial foil conductor surfaces (2), which comprise boundary lines which are as long as possible and run in parallel to the boundary lines of the large, standardised foil conductor surface (1).

2. An arrangement according to claim 1, **characterized in that** the mechanical components (3) are cuboid panels made of metal or plastic.

3. An arrangement according to either of claims 1 or 2, **characterized in that** the mechanical components (3) are part of a housing (8).

4. An arrangement according to claim 1, **characterized in that** the electrical components (4) are sensors or actuators, or other electrical components.

5. A method for producing several assembly groups (7), which in each case comprise electrical and mechanical components (3, 4) on a large, standardised foil conductor surface (1), **characterized in that**, at least for one assembly group (7),
- the mechanical components (3) are mechanically connected to the foil conductor surface (1)
- the electrical components (4) are mechanically connected to the foil conductor surface (1)
- the electrical components (4) are electrically connected to the foil conductor surface (1) and
- in each case, the part (2) of the foil conductor surface (1) which in each case comprises one assembly group (7), is separated along specified boundary lines from the foil conductor surface (1).

6. A method according to claim 5, **characterized in that** several electrical and mechanical components (3, 4) are compiled on the foil conductor surface (1) into assembly groups (7) in such a manner that the individual assembly groups (7) are arranged on partial foil conductor surfaces (2) which comprise boundary lines which are as long as possible and run in parallel to the boundary lines of the large, standardised foil conductor surface (1).

7. A method according to either of the above claims 5 or 6 for producing assembly groups (7) which comprise several electrical and mechanical components (3, 4) on partial foil conductor surfaces (2), **characterized in that**
- the mechanical connection of the mechanical components (3) is achieved using laminated-on, SMD assembled or mechanical joining;
- on the side located opposite the mechanical component (3) of the partial foil conductor surface (2), electrical contact surfaces are attached;
- the mechanical connection of the electrical components (4) is achieved using soldering or welding;
- the electrical connection of the electrical components (4) is produced by the contacts (6).

8. A method according to claim 7, **characterized in that** the distribution of the partial foil conductor surfaces (2) on the large foil conductor surface (1), the position of the boundary lines and the resulting form of the partial foil conductor surfaces (2), including the distribution of the components (3, 4) on the partial foil conductor surface (2), are selected in such a manner that the residue which remains following the separation is reduced to a minimum.

## Revendications

1. Disposition de composants électriques et mécaniques (3, 4) sur un conducteur plat flexible, lequel
- est une grande surface de conducteur plat standardisée (1), **caractérisée en ce que**
- les composants mécaniques (3) sont reliés mécaniquement avec la surface de conducteur plat (1) ;
- les composants électriques (4) sont reliés mécaniquement avec la surface de conducteur plat (1);
- les composants électriques (4) sont reliés électriquement avec la surface de conducteur plat (1).
et **en ce que** plusieurs composants électriques et mécaniques (3, 4) sont assemblés en modules (7) sur la surface de conducteur plat (1) de telle sorte que les différents modules (7) sont disposés sur des surfaces partielles de conducteur plat (2), lesquelles présentent des lignes de délimitation aussi longues que possible, s'étendant parallèlement le long des lignes de délimitations de la grande surface de conducteur plat (1) standardisée.

2. Disposition selon la revendication 1, **caractérisée en ce que** les composants mécaniques (3) sont des plaques rectangulaires en métal ou en plastique.

3. Disposition selon les revendications 1 ou 2, **caractérisée en ce que** les composants mécaniques (3) font partie d'un boîtier (8).

4. Disposition selon la revendication 1, **caractérisée en ce que** les composants électriques (4) sont des capteurs ou des actuateurs ou d'autres composants électriques.

5. Procédé pour la fabrication de plusieurs modules (7), lesquels comprennent respectivement des composants électriques et mécaniques (3, 4), sur une grande surface de conducteur plat standardisée (1), **caractérisée en ce que**, au moins pour un module (7)
- les composants mécaniques (3) sont reliés mécaniquement avec la surface de conducteur plat (1)
- les composants électriques (4) sont reliés mécaniquement avec la surface de conducteur plat (1)
- les composants électriques (4) sont reliés électriquement avec la surface de conducteur plat (1)
- la partie respective (2) de la surface de conducteur plat (1), laquelle comprend respectivement un module (7), est séparée de la surface de conducteur plat (1) le long de lignes de délimitations spécifiées.

6. Procédé selon la revendication 5, **caractérisé en ce que** plusieurs composants électriques et mécaniques (3, 4) sont assemblés en modules (7) sur la surface de conducteur plat (1) de telle sorte que les différents modules (7) sont disposés sur des surfaces partielles de conducteur plat (2), lesquelles présentent des lignes de délimitation aussi longues que possible, s'étendant parallèlement le long des lignes de délimitation de la grande surface de conducteur plat (1) standardisée.

7. Procédé selon l'une des revendications précédentes 5 ou 6 pour la fabrication de modules (7), lesquels comprennent plusieurs composants électriques et mécaniques (3, 4), sur des surfaces partielles de conducteur plat (2), **caractérisé en ce que**
- la liaison mécanique des composants mécaniques (3) est réalisée par laminage, montage en surface ou assemblage mécanique ;
- des surfaces de contact électriques sont posées sur la face de la surface partielle de conducteur plat (2) opposée aux composants mécaniques (3) ;
- la liaison mécanique des composants électriques (4) est réalisée par brasage ou par soudage ;
- la connexion électrique des composants électriques (4) est réalisée par les contacts (6).

8. Procédé selon la revendication 7, **caractérisé en ce que** la répartition des surfaces partielles de conducteur plat (2) sur la grande surface de conducteur plat (1), la position des lignes de délimitation et la forme des surfaces partielles de conducteur plat (2) en résultant, y compris la répartition des composants (3, 4) sur la surface partielle de conducteur plat (2), sont choisies de telle sorte que l'excédent restant lors de la séparation est réduit à un minimum.
